Europäisches Patentamt

European Patent Office

Office européen des brevets

(11) Publication number : **0 487 196 A1**

(12) **EUROPEAN PATENT APPLICATION**

(21) Application number : **91309067.6**

(22) Date of filing : **03.10.91**

(51) Int. Cl.$^5$ : **H01L 21/48, H01G 4/30, C04B 41/51**

(30) Priority : **11.10.90 US 596122**

(43) Date of publication of application :
**27.05.92 Bulletin 92/22**

(84) Designated Contracting States :
**BE DE FR GB IT NL**

(71) Applicant : **THE BOC GROUP, INC.**
**575 Mountain Avenue**
**Murray Hill New Jersey 07974 (US)**

(72) Inventor : **Tamhankar, Satish S**
**2111 Algonquin Drive**
**Scotch Plains, New Jersey 07076 (US)**
Inventor : **Kirschner, Mark J**
**38 Mt. Kemble Avenue**
**Morristown, New Jersey 07960 (US)**

(74) Representative : **Wickham, Michael et al**
**c/o Patent and Trademark Department The**
**BOC Group plc Chertsey Road**
**Windlesham Surrey GU20 6HJ (GB)**

(54) **Method for preparing multilayered ceramic article.**

(57)    Multiple "green" ceramic sheets are formed from a particulate ceramic material and a volatilisable organic binder, have individually printed thereupon a pattern containing conductor metal/metal oxide material from a suitable printing composition, and are thereafter assembled in registry with each other and laminated. Each such article is subjected to a heat treatment comprising a first heating stage under conditions to promote burn-out of the organic polymeric binder present, a second stage performed under conditions to reduce the metal oxide to metal, and a third stage to sinter the ceramic to form the final ceramic article. Moisture (water vapour) is present in an amount of from about 0.5% to about 3% volume of the gaseous atmosphere in at least the sintering stage, and preferably in both the binder burnout stage and the reduction stage as well. Multilayered articles heat treated under these conditions exhibit a combination of improved properties, including little or no staining in combination with improved conductivity and dielectric properties. In a preferred embodiment, the present method may be performed as a continuous process without the need for cool-down and heat-up of the laminate, in a continuous furnace with an atmosphere that is microprocessor-controlled. Catalytic generation of the moisture containing heating atmosphere may be utilised to further reduce cost and processing time while increasing process efficiency and productivity.

FIG. I

The present invention relates to a method for preparing a multilayered ceramic article by the assembly, lamination and firing of a plurality of "green" ceramic sheets (or tapes) having disposed thereon conductive pathways defined by copper or copper-containing materials and which exhibit a combination of improved conductivity with little or no staining. The term "multilayered" as used herein indicates two or more layers. The term "green" indicates that an article has not been subjected to heat treatment to sinter the ceramic.

The preparation of such multilayered ceramic hybrid articles is well-known. Such articles are in extensive use in the semiconductor industry for the fabrication of, for example, substrate carriers for the mounting of semiconductor or integrated circuit chips, laminated ceramic capacitors, or the like. These products have been traditionally produced by either a thick film printing method, or by what is known as a green sheet lamination method.

The thick film printing method comprises the formation of a multilayered structure based upon a fired ceramic base. The multilayered structure is achieved by the sequential screen printing of conductor and insulator inks comprising, respectively, metal or metal oxide powders and ceramic powders, usually formulated in an organic polymeric binder. These coatings are selectively applied in consecutive fashion. This method suffers from the drawbacks that repetitive applications of the insulator or dielectric material must be applied to achieve each layer and the resulting substrate must be fired after each printing process. The repeated heating cycles required by a method adds undesired time and expense to fabrication and the ultimate cost of the product. It is moreover noted that the thick film printing method is limited in the density that can be achieved with interconnect circuitry, and is likewise prone to low production yields. Other drawbacks include ceramic layer hermeticity that results directly from the use of screen printing methods to form the various layers, and the inability of the bonding agents conventionally employed in metal pastes to function acceptably in the nitrogen firing atmospheres that are required to avoid undesired oxidation of the conductor metal.

The green sheet lamination method comprises the printing of desired metal circuits on individual green ceramic sheets, which sheets are then stacked and successively laminated and thereafter co-fired to form a monolithic interconnected structure or package. This method generally may commence with the preparation of the ceramic green tape by, for example, a doctor blade casting process from a slurry containing a mixture of ceramic powders, thermoplastic resin binder, solvents, and other additives, such as dispersants and plasticisers. Vinyl polymers such as polyvinylbutyral (PVB) are commonly used in the resin system for the formation of the tape. After formation, the green tape is then blanked into sheets and registration holes are punched. "Via" holes which serve as vertical interconnections between layers in the final package may be punched using fixed tooling or corresponding adjustable equipment. The holes are then filled and circuit trace patterns are printed using the desired metallisation compositions. After the individual sheets are prepared, they are stacked in the proper sequence and laminated to form the composite laminate. The laminate is then fired to decompose and remove the organic binder and to sinter the ceramic and metal particles, thereby to form a dense body containing the desired three-dimensional wiring pattern.

The preparation of multilayered ceramic circuit structures involving the green sheet method is extensively treated in the patent literature. Thus, US-A-3,770,529 discloses the preparation of such structures and specifically relates to the machining of the green sheets by radiation beams. US-A-3,852,877 relates to a metallising coating of specific composition. US-A-4,861,646 discloses a particular glass ceramic composition binder system and metal "ink" for the preparation of improved green sheets. US-A-4,871,608 relates to a particular conductor paste which includes copper/copper oxide and one of $MnO_2$ and $Ag_2O$ to limit thermal contraction of the conductor paste during firing.

Of the stages involved in the fabrication of multilayered ceramic substrates, attention has been focused on the heating of the laminated structure to form the final sintered article. As can be appreciated, the heating procedure seeks to achieve distinct objectives, among them complete burn-out of the organic polymeric binder without the retention of carbonaceous residues or undesired porosity in the final article, and unwanted oxidation or reduction of the ceramic and metal components of the composite. A difficulty in carrying out the heating has been the balancing of the need for sufficient oxidation to remove the binder completely with the need for either a neutral or reducing atmosphere, as the case may be, to maintain in or convert to the metallic state, the conductive material while retaining the oxidic state of the surrounding ceramic materials during high temperature baking and sintering.

The following patents are noted for their relevance to the heat treatment of multilayered ceramic circuits prepared with ceramic green sheets. Thus, US-A-4,153,491 relates to the acceleration of sintering of a multilayered ceramic hybrid circuit by eliminating a separate binder burn-off step. A ceramic green sheet based on high alumina content particles having average particle sizes greater than one micron, and close particle size distribution appear to be employed.

US-A-4,877,555 discloses a conductor paste that comprises CuO as a main inorganic component, with an additive selected from $Cu_2O$ and CuO. US-A-4,877,555 teaches the preparation of a multilayer structure by the disposition of their conductor paste and a dielectric paste in a predetermined sequence, followed by the heat treatment of the resulting structure, first to remove the binder, then to metallise the internal conductor (i.e. to reduce the copper oxides to copper metal) and lastly, to fire the final product. The first heat treatment is performed in air, the metallisation is performed in a reducing atmosphere, and the firing step is performed in a neutral atmosphere. US-A-4 877 555 discloses the control of shrinkage and expansion of the copper conductor by varying the amounts of the above-noted inorganic components. It is purported that the method according to US-A-4 877 555 permits the use of a relatively thin conductor layer and dielectric layer in the preparation of the laminated articles. This result is desired in the manufacture of capacitors having a small size but a large capacitance.

In US-A-4,863,683 a method for preparing a multilayer conductor is disclosed where the conductor metals are provided as oxides which are converted to the metallic state during heating. First the composite articles is heated to burn out the binder, and then the article is heated in a reducing atmosphere to reduce the metal oxides. Both the binder burn-out and reduction steps are performed at temperatures below the sintering temperature of the glass or ceramic components of the insulating paste, to encourage conversion of the metal oxides of the conductor layers to the metallic state. Thereafter, the body is heated in a neutral atmosphere such as nitrogen to sinter the body to form the final multilayered article. As in US-A-4,877,555 a three-stage heating schedule is disclosed, although different conductor pastes and heating steps are described.

US-A-4,234,367 discloses an atmosphere of $H_2$ and $H_2O$ at temperatures below the melting point of copper, i.e., of up to about 785°C. Sintering, however, is conducted in an inert atmosphere such as $N_2$, and $H_2O$ is not present. US-A-4,504,339 is similar to US-A-4 234 367 in that it discloses the use of water vapour in the binder burn-off atmosphere. US-A-4,504,339 expressly discloses the exclusion of water vapour from the firing or sintering atmosphere, to avoid oxidation of the conductive copper pattern. Finally, US-A-4,891,246 relates to the use of a firing atmosphere that includes $CO/CO_2$ and water in combination, and distinguishes the use of $H_2O$ alone. US-A-4,891,246 is particularly noteworthy for its review of the prior art, which review is incorporated herein by reference.

From the above review and as particularly set forth in US-A-4,877,555 and US-A-4,863,683 the heating program for these multilayered ceramic structures has generally been conducted in three stages, as follows: a first binder burn-out stage; a second reducing stage; and a third firing or sintering stage.

An additional concern that has been noted and is not addressed in the prior art, however, has to do with the staining of the ceramic phase of the structure by copper inclusions. More particularly, ionic copper is believed to diffuse into the ceramic/glass phase of the composite during binder burn-out and the early part of the sintering step, and during sintering, is believed to be reduced to a lower oxidation state which exhibits the characteristic purple or pink colour of the metal. This reduction is believed to occur as a result of the low oxidation potential of the nitrogen atmosphere present during the sintering step.

As the bulk of the copper needs to be protected from oxidation at this stage, the addition of oxygen is generally avoided. Thus, the modulation of the composition of the firing atmosphere to achieve the desired combination of properties is further complicated by the unacceptable appearance that results from the unwanted diffusion of copper. A need therefore exists to reduce or eliminate staining of the composite article while maintaining or improving product integrity, conductivity and other desirable performance properties thereof.

According to the present invention, there is provided a method of forming a multilayered ceramic article, comprising the steps of:

(i) forming ceramic sheets from ceramic particles and a volatilisable organic binder;

(ii) depositing a conductor pattern on each sheet from a printing composition including an oxide of a conductive metal;

(iii) laminating the sheets;

(iv) heat treating the laminated article, wherein the heat treatment step comprises the steps of:

a) heating the article to remove all organic binder present;

b) further heating the article to reduce the oxide of the conductive metal to the metal itself; and

c) further heating the article to sinter the ceramic, whereby the finished article includes internal conductor elements, characterised in that the heating atmosphere in step c incudes from about 0.5 to about 3% by volume of water vapour.

The atmosphere in step (c) preferably contains from about 1% to about 2% by volume of water vapour. Preferably, water vapour is also present in the heating atmosphere used in step (a), and most preferably in step (b) as well, the concentration of water vapour being within the above ranges.

In addition to reducing or eliminating staining, the present method achieves improved binder burn-out and enhances the extent of reduction when moisture is included in the reducing stage. The resulting composite article exhibits greater integrity, reduced porosity and correspondingly improved conductivity and dielectric properties. Moreover, the atmospheric requirements of the present process are less stringent, as, for example, as

little as 1% $O_2$ may be added to the binder burn-out atmosphere when moisture is present, with satisfactory results for certain applications.

The method according to the invention may be performed on a continuous basis and can thereby be completed in as little as 24 hours or less, which is a substantial reduction in processing time over that achieved in the prior art. The continuous practice of the present method contemplates the residence of the composite within a single furnace which might either be a box-type furnace with a programmed atmosphere or a belt-type furnace with curtains disposed between the various sections of the furnace where changes in the heating atmosphere would be made. The heating atmosphere in a continuous processing environment of this kind would utilise a primary component of moist nitrogen. The transition from a binder burn-out atmosphere to a reducing atmosphere could be accomplished by the initial introduction of a quantity of oxygen which, as mentioned earlier, could be as little as 1%, followed by a transition to hydrogen at the termination of the binder burn-out stage and the commencement of the reduction stage.

Preferably, the transition from binder burn-out to reducing atmosphere could be achieved by the generation of moisture with a catalytic humidifier. In such instance, the operation of the humidifier could be modulated first, to provide the additional oxygen required for binder burn-out, and thereafter, to offer additional hydrogen for the reducing stage. A representative catalytic humidifier is disclosed in US-A-3,630,956 the disclosure of which is incorporated herein by reference. Other comparable gas generating means may be used.

The method according to the invention is now described by way of example with reference to the accompanying drawings in which:

FIGURE 1 is a graph illustrating a heating schedule including temperature and atmospheric parameters, able to be used when the method according to the invention is operated continuously.

FIGURE 2 is a graph illustrating the increased rate of reduction achieved in the reduction stage of the invention, as compared with the known reduction step wherein moisture is not present.

FIGURE 3 is a graph illustrating the results of a comparison similar to that of Figure 2 derived from the heating of a copper/copper oxide paste disposed on a pre-fired alumina substrate which is directly exposed to the atmosphere.

FIGURE 4 is a flow diagram illustrating an apparatus suitable for the performance of the method according to the invention.

In its broadest aspect, the present invention relates to the heat treatment of multilayered ceramic/glass composite articles formed from "green" ceramic sheets, which glass composite articles bear internal copper conductor patterns derived from the printing of copper/copper oxide-containing printing pastes on individual layers of the article. The articles themselves are well-known and the compositions of the green sheets and the copper conductor pastes are likewise well-documented in the art. The primary aspect of the present invention relates to the parameters that attend the heat treatment of the laminated composite article to form the final multilayered ceramic article.

As mentioned earlier, the formation of such multilayered ceramic articles has required careful process controls to optimise the properties of the resulting article. The prior art discussed above is replete with reference to the undesirable consequences of excessive oxidation or reduction of the composite article during binder burn-out and sintering. Thus, excessive oxidation can result in unwanted oxidation of the conductor metal and concomitant reductions in conductivity and dielectric properties, while insufficient oxidation will result in the retention of carbonaceous residues which will cause voids to form in the final article, thereby detracting from its structural integrity and consequent utility as an electrical device.

In addition to the concerns noted in the prior art with respect to binder burn-out and control of conductor oxidation/reduction, Applicants have noted the occurrence of unwanted ceramic staining apparently caused by unwanted diffusion of copper into the ceramic or glass phase during heat processing. As mentioned earlier, Applicants postulate that copper diffuses into the glass phase during binder burn-out as well as upon the commencement of sintering, and forms the unwanted stain as the former is reduced to a lower oxidation state. Although such stains are commercially unacceptable, their control heretofore has gone uncorrected and, for that matter, has never been formally addressed in the art.

In this context, the present invention is made all the more distinctive, in that Applicants have noted the drawbacks of copper-induced staining and have solved this problem by the development of the present heat treatment method. In accordance with this method, a quantity of moisture is introduced at least, at the sintering stage, and preferably at both the binder burn-out and sintering stages of a three-stage heat treatment, whereupon staining is substantially reduced or eliminated. Most preferably, moisture (water vapour) may be present in the burn-out, reducing and sintering stages, whereupon optimal properties, including improved conductivity and dielectric properties and the absence of staining may be attained.

The concentration of moisture during the present heat treatment may be maintained at an amount ranging from about 0.5% to about 3% by volume, balance being the primary or purge gas of the heating atmosphere, and preferably may be from about 1% to about 2% by volume, most preferably at or about 2%, during the sintering stage. The temperature ranges employed in the heat treatment may otherwise be as known in the art, and, for example, the binder burn-out stage may be conducted up to a temperature of about 500°C, the reduction stage may also be conducted at a temperature up to about 500°C and the sintering or firing stage may be conducted at temperatures of up to about 920°C. Naturally, the foregoing temperature parameters are exemplary only, as variations in these temperature levels may be made in accordance with such factors as the exact composition of the green sheet and conductor paste compositions and the particular heating apparatus or system in use.

One of the aspects of the present invention that makes it particularly advantageous is the ability to conduct binder burn-out effectively and completely while, at the same time, reducing oxygen requirements. This is considered particularly noteworthy in view of the fact that such a multilayered composite article has conventionally required additional oxygen or other oxidising gas in the burn-out atmosphere due to its multilayered configuration, and that such additional oxidising gas has generally resulted in unwanted oxidation of the conductor metal. In the present instance, the use of moisture within the ranges hereinbefore specified facilitates the presence of from about 2% to about 20% of oxygen in the burn-out atmosphere, preferably from about 2% to about 5%, and in some instances, as little as 1%. This is clearly distinguishable from the burn-out atmospheres shown in the prior art illustrated herein, which generally utilise at least 21% oxygen, particularly in the instance where air is used as the primary or purge gas. The reduction in oxygen carries with it a corresponding economy in that oxygen consumption is substantially reduced.

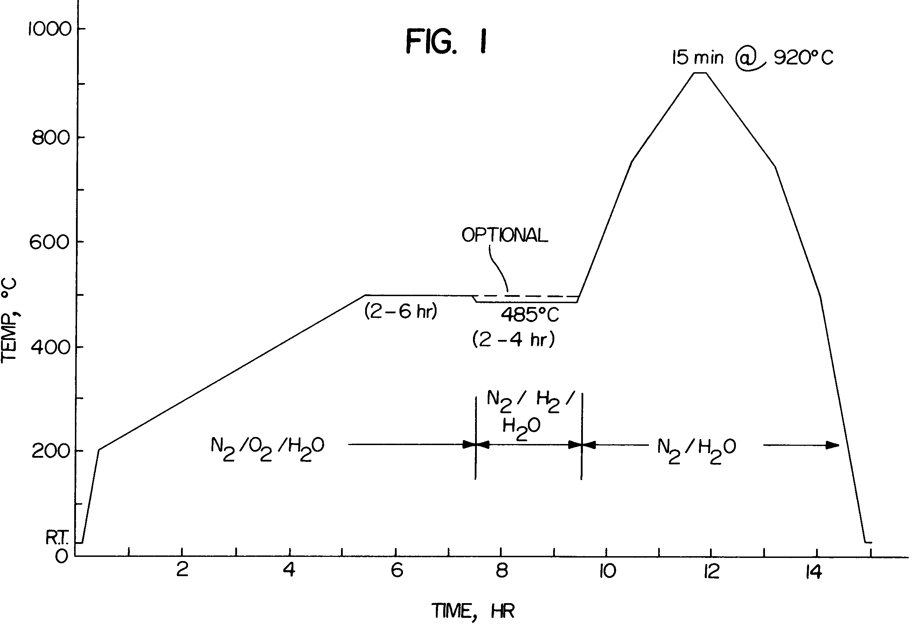

A representative scheme for the present invention is illustrated in Figure 1, wherein the parameters of a continuous process are graphically depicted. In continuous process a primary or purge gas of wet nitrogen is used, whose composition in the burn-out region would be adjusted by the introduction of oxygen in amounts of from about 2% to about 20% by volume as indicated, and preferably, in an amount of from about 2% to about 5% by volume. In the reduction stage, the atmosphere would be modified by the introduction of hydrogen in an amount ranging from about 1% to about 10% by volume, and preferably, from about 1% to about 5% by volume without there being any addition of oxygen. After the completion of the reduction stage, the sintering stage could then commence, wherein the nitrogen based purge gas, supplemented with moisture, would be maintained. Preferably, the amount of moisture present in the sintering atmosphere of the third stage is at or about 2% by volume. Naturally, the foregoing parameters may be modified somewhat, in the instance where the main gas in the burn-out region is air or another acceptable primary ambient, it being understood that the inclusion of moisture during at least the sintering stage, and preferably during both the burn-out and sintering stages of the present method, and within the general ranges set forth herein, is maintained.

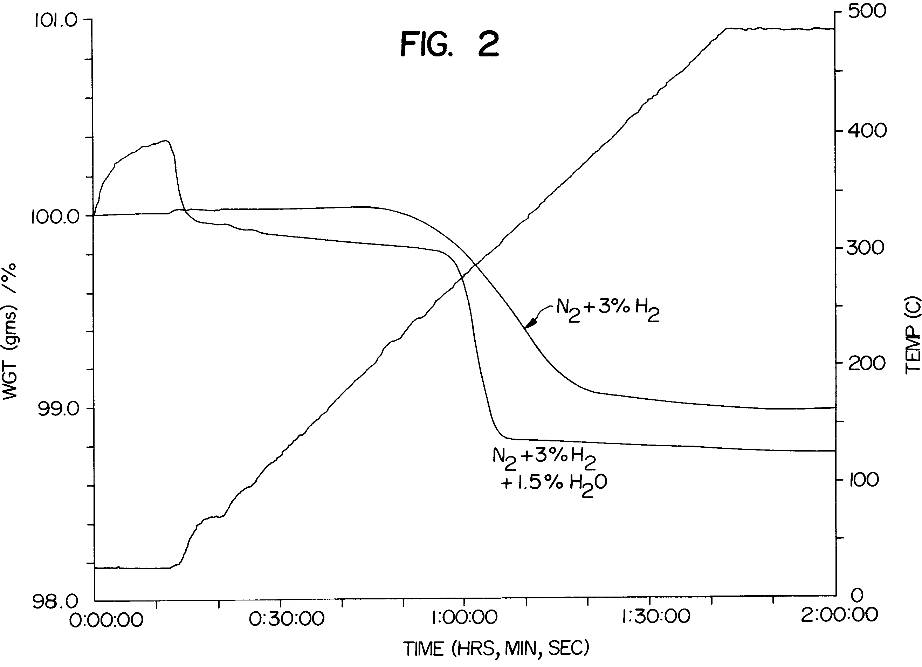

The present method is likewise distinguishable in its performance during the reduction stage, as unexpected improvements in the rate of reduction are achieved herein. Inasmuch as the presence of moisture has been traditionally considered as an oxidising influence rather than a reducing influence, the acceleration in the rate of reduction that is achieved herein is noteworthy. Referring to Figure 2 herein, the rate of reduction achieved with the present atmosphere is compared with that achieved with an atmosphere containing nitrogen and hydrogen alone, and it can be seen that reduction is achieved over a shorter period of time when moisture is present in the amounts set forth herein.

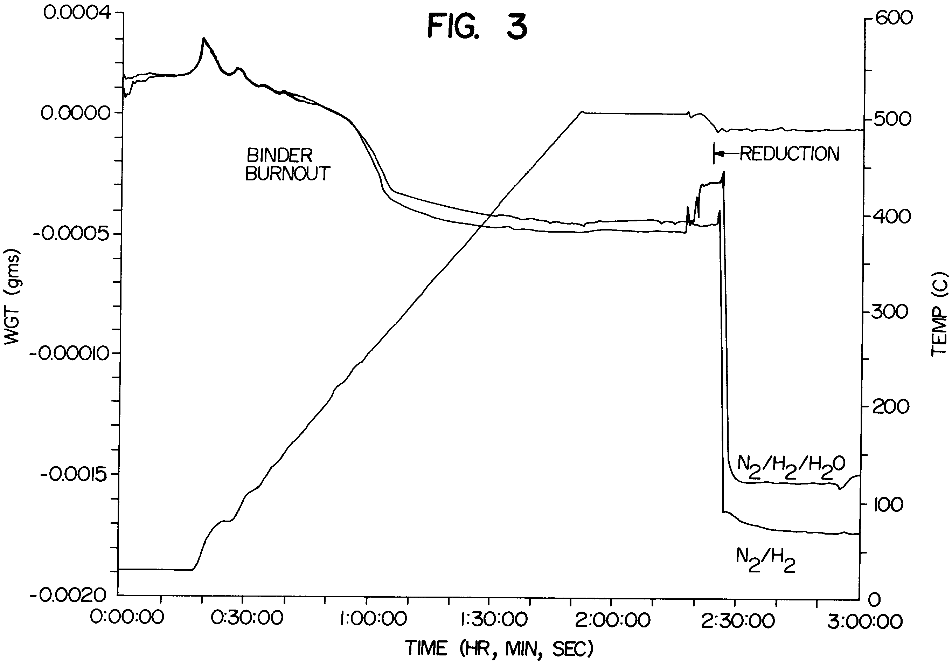

An interesting comparison, however, can be made between the present invention as it relates to multilayered ceramic articles and the use of similar parameters in a reducing atmosphere for a single layered conductive ceramic article. Specifically, and with reference to Figure 3, a single pre-fired alumina substrate was coated with a copper/copper oxide paste which was then heat treated in a reducing atmosphere identical to the respective atmospheres compared in Figure 2. That is, a first reducing atmosphere employing nitrogen with a quantity of hydrogen and a second reducing atmosphere including, in addition thereto, a quantity of moisture, were compared with identical single-coated substrates, distinctive in the exposed disposition of the copper conductor paste.

In this latter instance, the rate of reduction in the atmosphere containing moisture was comparable to that of the atmosphere wherein moisture was absent. This suggests that a unique phenomenon takes place in the situation where the conductor paste or like material is disposed within the ceramic matrix as it is in a laminated multilayered green article.

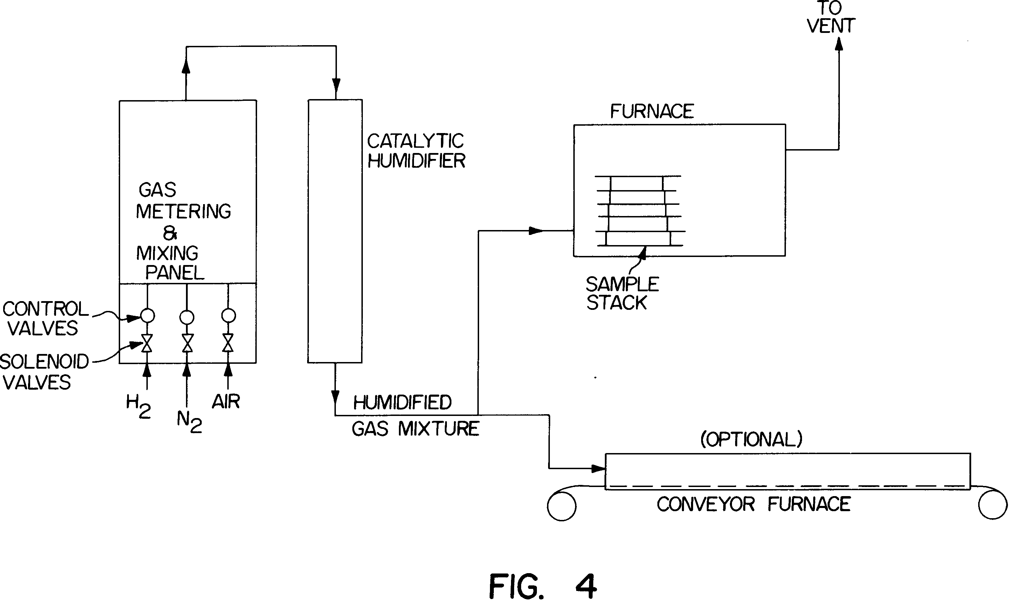

Referring again to Figure 1 and also to Figure 4 of the drawings, the method according to the present invention may be operated continuously to reduce the overall time requirements of the process and to offer corresponding economies of processing. It can be seen from Figure 1 that the transition from binder burn-out to reduction, and from reduction to sintering, can be achieved without the need for the cooling of the composite article and the subsequent heating up thereof that would be necessary in the instance where each stage of heat processing requires a distinctive atmosphere and other attendant conditions that could not be achieved in a single facility. In the present scheme, a main purge gas such as wet nitrogen can be used throughout, and variations in the amount of oxygen during binder burn-out or the amount of hydrogen during subsequent reduction could be made in a single facility, all as illustrated schematically in Figure 4.

Referring now to Figure 4, a proposed apparatus is depicted which would include a catalytic humidifier operated in conjunction with, for example, a muffle furnace that is equipped with a programmable heater control. In this instance, the main purge gas as mentioned earlier would be moist nitrogen which could be achieved by either bubbling nitrogen through water or by utilising a catalytic humidifier such as schematically depicted. During the first binder burn-out step, oxygen at the levels indicated above, would be added to the main gas. At the end of binder burn-out, oxygen flow would be reduced, and upon adjustment of the temperature level for performance of the reduction stage, hydrogen flow within the ranges indicated above would commence. After reduction is complete, the flow of hydrogen is reduced, and an atmosphere comprising wet nitrogen continues as the sole ambient for the remainder of the process. The control of the flow of oxygen and hydrogen could be achieved with solenoid valves which would be programmed for specific time sequences based upon the temperature profile of the process, utilising, for example, a microprocessor.

As mentioned earlier, the catalytic humidifier that may be used in accordance with the present invention may be similar in construction and operation to that disclosed in US-A-3,630,956, incorporated earlier herein by reference. Thus, for example, nitrogen may be fed into the reactor vessel containing a noble metal based catalyst, such as palladium, whereupon oxygen and hydrogen would react on the surface of the catalyst to produce water. Such a process may be operated on an automated basis, as mentioned above, and the extent of hydrogen or oxygen introduced may be appropriately varied to achieve the unreacted quantities of each that would be desired, respectively, in the binder burn-out and reduction heating stages.

The preparation of multilayered ceramic circuits is itself known. For example, appropriate ceramic tapes or sheets are prepared and conductor patterns are applied to them by such techniques as screen printing of appropriate copper/copper oxide-containing printable pastes. Generally, the green ceramic tapes or sheets are cut into blanks to the desired size for a particular multilayered article, after which "via" holes are punched which are consistent with the circuit design. These holes are then filled with the conductor paste by, for example, a contact printing method, after which the desired conductor patterns are screen printed onto the different tape layers. The layers are thereafter stacked together in a die and laminated by applying pressure and temperature within known parameters. The device as prepared is then ready for processing in accordance with the present invention.

Suitable materials for the formation of the multilayered ceramic composite articles processable in accordance with the present invention are themselves well-known. The green tapes are generally prepared from compositions including various glass and ceramic ingredients, such as, for example, various silicate glasses, alumina, quartz and the like, in mixture with a suitable volatalisable organic binder. The binder may be selected from natural or synthetic resins and would include, for example, cellulosic resins such as ethylcellulose, vinyl polymer such as polyvinylbutyral and acrylic and methacrylic polymers and copolymers. Additional ingredients including plasticisers, vehicles and the like are likewise contemplated, and the invention is not accordingly limited to the exact compositions or the ingredients herein.

Likewise, the conductive pastes would include mixtures of copper and copper oxides, with the latter being preponderant. The organic binder for the conductive paste could be the same or similar to the binders employed in the green ceramic tape, and the exact composition thereof may likewise vary in accordance with the present invention.

As mentioned earlier, the present method is predicated upon the presence of moisture at the binder burn-out and sintering stages, to achieve the unexpected reduction in copper diffusion and resultant ceramic staining. Particularly, comparative tests of like composite articles were made within the scope of the present invention, with heating atmospheres that differed only in the presence or absence of moisture. Such comparison is set forth in Table 1, below.

## TABLE 1

### Staining Characteristics

| Run No. | Burn-out | Reduction | Sintering | Result |
|---|---|---|---|---|
| 1 | $Air/H_2O$ | $N_2/H_2/H_2O$ | $N_2/H_2O$ | No staining |
| 2 | $Air/H_2O$ | $N_2/H_2/H_2O$ | $N_2$ | Stained |
| 3 | Air | $N_2/H_2$ | $N_2/H_2O$ | Some staining |
| 4 | $Air/H_2O$ | $N_2/H_2$ | $N_2/H_2O$ | No staining |
| 5 | Air | $N_2/H_2/H_2O$ | $N_2/H_2O$ | Some staining |

Referring now to Table 1, it will be noted that the binder burn-out stage in this instance utilised air as the primary ambient, whereas nitrogen was the primary ambient in both the reduction and sintering stages. This illustrates the fact that the present invention may be performed with variation as to the particular primary ambient involved so long as the general character of the atmosphere used at each stage is maintained.

More importantly, a review of Table 1 reveals that no staining was evident in Run Nos. 1 and 4, where water vapour was present in both the burn-out and sintering stages. Mild staining was found in the instance of Run Nos. 3 and 5, where moisture was present either in the sintering stage alone, and in both the sintering and reduction stages, respectively. Clearly, the most significant staining occurred in the instance where moisture was absent from the sintering stage and, for this reason, the present invention in its most essential aspect, comprises the employment of moisture at that last heat processing stage.

Likewise, and as indicated earlier, the present method permits as little as 1% added oxygen during binder burn-out to achieve desirable properties in the resultant fired composite. Thus, and with reference to Table 2, it can be seen that a variety of processing atmospheres may be employed when moisture is present, and even in the instance where the burn-out atmosphere employs a quantity of oxygen of at least 1% concentration, the combination of desirable properties in the resulting composite is able to be optimised.

## TABLE 2

### Effects of Burn-out Atmospheres on Staining

| Run No. | Burn-out | Reduction | Sintering | Result |
|---|---|---|---|---|
| 6 | $N_2/H_2O$ TO $Air/H_2O$ @400/C | $N_2/H_2/H_2O$ | $N_2/H_2O$ | No staining; copper extruded |
| 7 | $Air/H_2O$ | $N_2/H_2/H_2O$ | $N_2/H_2O$ | No staining |
| 8 | $N_2/H_2O$ | $N_2/H_2/H_2O$ | $N_2/H_2O$ | Dark grey; copper extruded |
| 9 | $N_2/O_2/H_2O$ | $N_2//H_2/H_2O$ | $N_2/H_2O$ | No staining; no extrusion |

$O_2 = 1\%;\ H_2 = 3\%;\ H_2O = 1.5\%$

Referring further to Table 2, it can be seen in Run Nos. 6, 7 and 9, where burn-out atmosphere carried with it a quantity of oxygen, no staining was evident. Run No. 9 illustrates the presence of as little as 1% oxygen in a nitrogen and water vapour burn-out atmosphere, and yielded neither staining of the composite, nor extrusion of the copper.

It should be noted that the phenomenon of extrusion referred to in Table 2 occurs in the absence of oxygen, as ceramics or metals undergo uneven expansion and/or contraction, with the result that the metal is pushed or "extruded" out of the composite and a mechanical distortion of the product occurs. This phenomenon is undesirable and is generally attributable to the uneven shrinkage characteristics of the components of the composite.

This invention may be embodied in other forms or carried out in other ways without departing from the spirit or essential characteristics thereof. The present disclosure is therefore to be considered as in all respects illustrative and not restrictive, the scope of the invention being indicated by the appended Claims, and all changes which come within the meaning and range of equivalency are intended to be embraced therein.

## Claims

1. A method of forming a multilayered ceramic article, comprising the steps of:
   (i) forming ceramic sheets from ceramic particles and a volatilisable organic binder;
   (ii) depositing a conductor pattern on each sheet from a printing composition including an oxide of a conductive metal;
   (iii) laminating the sheets;
   (iv) heat treating the laminated article, wherein the heat treatment step comprises the steps of:
      a) heating the article to remove all organic binder present;
      b) further heating the article to reduce the oxide of the conductive metal to the metal itself; and
      c) further heating the article to sinter the ceramic, whereby the finished article includes internal conductor elements, characterised in that the heating atmosphere in step c incudes from about 0.5 to about 3% by volume of water vapour.

2. A method according to Claim 1, wherein said water vapour is present in Steps a. and c in an amount of from 0.5 to 3.0% by volume.

3. A method according to Claim 1 or Claim 2, wherein said moisture is present in Steps a., b. and c in an amount of from 0.5 to 3.0% by volume.

4. A method according to any one of Claims 1 to 3, wherein Steps a., b. and c. are performed consecutively without intermediate cool-down and warm-up steps.

5. A method according to any one of the preceding claims wherein said moisture is generated by the catalytic reaction of hydrogen and oxygen.

6. A method according to any one of the preceding claims, wherein the heating atmosphere for Step a. is an oxidising atmosphere, and the heating atmosphere for Step c. is a neutral atmosphere.

7. A method according to any one of the preceding claims, wherein the atmosphere of Step a. contains from 1% to 20% by volume of oxygen; the atmosphere of Step b. contains from 1% to 10% by volume of hydrogen; and the atmosphere of Step c. comprises essentially nitrogen and water vapour.

8. A method according to any one of the preceding claims, wherein said water vapour is present in the sintering atmosphere in a range of from 1% to 2% by volume.

9. A method according to any one of the preceding claims, wherein the atmosphere of Step a. contains from 1% to 5% by volume of oxygen.

10. A method according to any one of the preceding claims, wherein the atmosphere of Step b. contains from 1% to 5% by volume of hydrogen.

11. A method according to any one of the preceding claims, wherein the atmosphere of step a is based on air or nitrogen and the atmosphere or step b is based on nitrogen.

12. A method according to any one of the preceding claims, in which the finished article is free of carbonaceous inclusions, has little or no staining from metallic inclusions, and exhibits improved conductivity and dielectric properties.

13. An article prepared by a method as claimed in any one of the preceding claims.

FIG. I

15 min @ 920°C

OPTIONAL

(2-6 hr)

485°C
(2-4 hr)

N$_2$/O$_2$/H$_2$O

N$_2$/H$_2$/H$_2$O

N$_2$/H$_2$O

TEMP, °C

R.T.

TIME, HR

EP 0 487 196 A1

FIG. 2

FIG. 3

FIG. 4

EP 0 487 196 A1

European Patent Office

**EUROPEAN SEARCH REPORT**

Application Number

EP 91 30 9067

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 326 499 (PECHINEY RECHERCHE) * page 2, line 30 - page 3, line 34 * --- | 1,6,7, 10-13 | H 01 L 21/48 H 01 G 4/30 C 04 B 41/51 |
| A | US-A-4 906 405 (MATSUSHITA ELECTRIC IND CO LTD) * example 5 * --- | 1 | |
| A | EP-A-0 164 841 (NGK INSULATORS LTD) ----- | | |

TECHNICAL FIELDS SEARCHED (Int. Cl.5)

H 01 L
H 01 G
C 04 B
H 05 K

The present search report has been drawn up for all claims

| Place of search | Date of completion of the search | Examiner |
|---|---|---|
| THE HAGUE | 20-01-1992 | SCHUERMANS N.F.G. |